**Europäisches Patentamt**

**European Patent Office**

**Office européen des brevets**

(11) Veröffentlichungsnummer: **0 153 626**

**A2**

(12) **EUROPÄISCHE PATENTANMELDUNG**

(21) Anmeldenummer: **85101268.2**

(22) Anmeldetag: **07.02.85**

(51) Int. Cl.⁴: **H 01 L 23/48**
**H 01 L 21/48, H 01 L 23/12**
**H 01 L 23/56**

(30) Priorität: **23.02.84 DE 3406537**

(43) Veröffentlichungstag der Anmeldung:
**04.09.85 Patentblatt 85/36**

(84) Benannte Vertragsstaaten:
**AT CH DE FR GB IT LI NL**

(71) Anmelder: **BROWN, BOVERI & CIE Aktiengesellschaft**
**Kallstadter Strasse 1**
**D-6800 Mannheim 31(DE)**

(72) Erfinder: **Neidig, Arno, Dr. Dipl.-Phys.**
**Brühlerweg 42**
**D-6831 Plankstadt(DE)**

(74) Vertreter: **Kempe, Wolfgang, Dr. et al,**
**c/o Brown, Boveri & Cie AG Postfach 351**
**D-6800 Mannheim 1(DE)**

(54) **Anordnung eines Leistungshalbleiterbauelementes auf einem isolierenden und mit Leiterbahnen versehenen Substrat.**

(57) Zur Verringerung des Aufwandes bei der Montage von Leistungshalbleiterbauelementen (5) bzw. von Leistungshalbleiter-Sandwich (13) auf mit Leiterbahnen (2) versehenen Keramiksubstraten (1) wird eine Anordnung vorgeschlagen, bei der die Leistungshalbleiter (5, 13) gegenüber der üblichen Montageweise umgekehrt montiert werden. Dabei ist die mit einer Hauptelektrode (17) und einer allseits von der Hauptelektrode (17) umschlossene Steuerelektrode (15) dem Substrat (1) zugekehrt. Das dabei entstehende Problem der Leitungszuführung zu der Steuerelektrode (15) wird durch ein metallisiertes keramisches Verbindungselement (14, 14.1) gelöst.

Fig 3

EP 0 153 626 A2

BROWN, BOVERI & CIE     AKTIENGESELLSCHAFT
Mannheim                        21. Febr. 1984
Mp.-Nr. 521/84                  ZPT/P3-Sf/Bt

Anordnung eines Leistungshalbleiterbauelementes auf
einem isolierenden und mit Leiterbahnen versehenen
Substrat

Die Erfindung bezieht sich auf eine Anordnung eines Leistungshalbleiterbauelementes auf einem isolierenden und
mit Leiterbahnen versehenen Substrat gemäß dem Oberbegriff des Anspruchs 1, die z.B. in Leistungshalbleitermodulen angewendet wird.

Üblicherweise werden Leistungshalbleiterbauelemente,
z.B. Thyristoren, auf Substraten so angeordnet, daß das
Bauelement mit der Anode nach unten auf die Leiterbahn
des Substrats gelötet wird. Gate-, Hilfskathode- und
Kathodenanschlüsse sind auf der Oberseite des Bauelementes angeordnet und mittels Kontaktbügeln mit Leiterbahnen verbunden. Eine solche Anordnung mit Kontaktbügeln
ist z.B. aus Patentanmeldung P 31 27 458.7-33 bekannt.

Diese übliche Anordnung ist bei umfangreicheren Schaltungen (z.B. Drehstrombrückenschaltungen) bei gleichzeitig hoher Packungsdichte schwierig zu handhaben und führt zu hohen Montageaufwendungen.

Der Erfindung liegt die Aufgabe zugrunde, eine Anordnung für Leistungshalbleiterbauelemente auf Substraten anzugeben, bei der vorstehende Nachteile vermieden werden.

Diese Aufgabe wird durch eine Anordnung gemäß dem Anspruch 1 gelöst. Ausgestaltungen sind in Unteransprüchen angegeben.

Mit der Erfindung wird eine Lösung vorgeschlagen, bei der Leistungshalbleiterbauelemente umgekehrt auf ein Substrat gelötet werden, so daß Gate- und Kathodenanschlüsse unten sind. Eine solche umgekehrte Montage ist an sich bekannt aus Patentanmeldung P 33 31 298.2, allerdings handelt es sich dort um Bauelemente, bei denen der Gate-Anschluß am Rand angeordnet ist und somit keine Probleme mit der Leitungsführung auf dem Substrat bestehen. Hier ist jedoch das Problem für Bauelemente zu lösen, die einen zentralen Steueranschluß bzw. allgemein einen allseitig z.B. von der Kathode umschlossenen Steueranschluß aufweisen.

Die erfindungsgemäße Lösung ist für Leistungshalbleiterbauelemente verschiedenster Art, wie z.B. Thyristoren oder Transistoren geeignet. Die Bezeichnung "Steuerelektrode" wird stellvertretend für Gate-, Basis- oder sonstige Hilfs- oder Steueranschlüsse verwendet. Die Bezeichnung "Hauptelektrode" entsprechend für Kathode, Anode, Emitter oder Kollektor. Selbstverständlich können nach dem angegebenen Lösungsprinzip auch mehrere Steuerelektroden an einem Leistungshalbleiterbauelement mit Leiterbahnen verbunden werden und es können mehrere Leistungshalbleiterbauelemente auf einem Substrat angeordnet sein.

Vorteile der erfindungsgemäßen Lösung bestehen darin, daß gegenüber der üblichen Anordnung weniger Kontaktbügel benötigt werden, nämlich nur für die oben liegende Hauptelektrode und das vorgesehene Verbindungselement in Ausschnitten in den Leiterbahnen vor und während des Lötens fixiert wird. Mit Hilfe des Verbindungselements können auch vorgelötete Sandwich fixiert werden.

Weitere Vorteile ergeben sich aus den Unteransprüchen und der nachstehenden Beschreibung von Ausführungsbeispielen anhand der Zeichnung.

Es zeigen:
Fig. 1     Substrat mit Leiterbahnen,
Fig. 2     bestücktes Substrat,
Fig. 3     Schnittbild eines Sandwich auf einem Substrat mit Verbindungselement,
Fig. 4     Schnitt durch ein Verbindungselement,
Fig. 5     Draufsicht auf das Verbindungselement,
Fig. 6     Unteransicht des Verbindungselements,
Fig. 7     vereinfachtes Verbindungselement,
Fig. 8     Schnitt durch vereinfachtes Verbindungselement,
Fig. 9     Schnitt durch Sandwich mit vereinfachtem Verbindungselement,
Fig. 10    Sandwich mit vereinfachtem Verbindungselement.

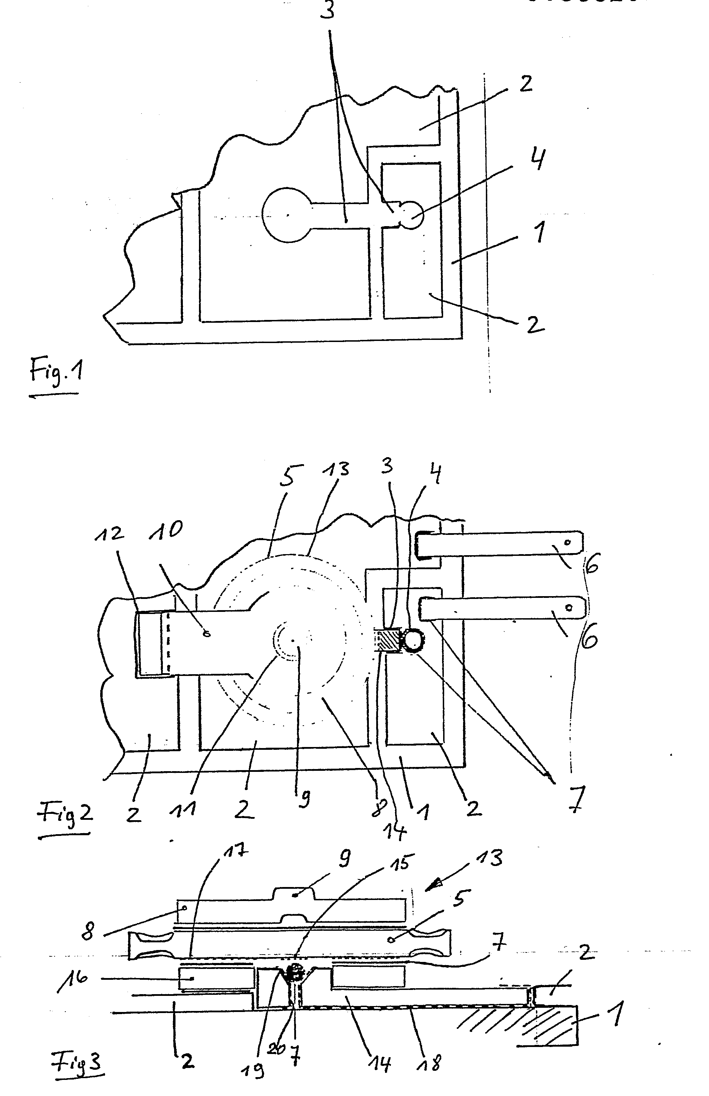

Fig. 1 zeigt ein keramisches Substrat 1, das mit Leiterbahnen 2 versehen ist. Die Leiterbahnen 2 weisen Ausschnitte 3 auf, in die ein keramisches Verbindungselement 14 eingelegt wird (siehe Fig. 2 bis 6). Die Ausschnitte 3 werden in einem Arbeitsgang gleichzeitig mit den Leiterbahnen 2 hergestellt, z.B. durch Ätzen der Metallisierung auf dem Substrat 1. Dabei wird ein Lotausschnitt 4 hergestellt, der zur Aufnahme einer Lotkugel oder eines Lotplättchens dient zur späteren Herstellung einer Lötverbindung zwischen Verbindungselement 14 und Leiterbahn 2.

Fig. 2 zeigt ein mit einem Leistungshalbleiterbauelement 5 und Anschlüssen 6 bestücktes und bereits gelötetes Substrat 1. Ein zuvor in den Lotausschnitt 4 eingelegtes Lot 7 in Form einer Kugel oder eines Plättchens ist bereits verlaufen. Die angelöteten Anschlüsse 6 werden nach oben gebogen. Weiterhin ist in Fig. 2 eine obere Kontaktronde 8 (z.B. Molybdänronde) mit einer Fixiernase 9 dargestellt. In die Fixiernase ist ein Kontaktbügel 10 mit einem Loch 11 eingehängt, der außerdem durch einen Fixierausschnitt 12 in der Leiterbahn 2 während der Lötung fixiert wird. Auf diese Weise kann ein vorgelötetes Sandwich 13 ohne zusätzliche Clips während der Lötung in einem Durchlaufofen fixiert werden. Das Sandwich 13 wird außerdem durch das in Ausschnitte 3 eingelegte Verbindungselement 14 fixiert.

Fig. 3 zeigt in einem Schnittbild deutlicher wie eine elektrische Verbindung zwischen einer Steuerelektrode 15, z.B. einem Thyristor-Gate, und einer Leiterbahn 2 außerhalb des vom Leistungshalbleiterbauelement 5 überdeckten Bereiches mit Hilfe eines Verbindungselementes 14 hergestellt wird. Das Verbindungselement 14 liegt in Ausschnitten 3 (siehe Fig. 1 und 2) der Leiterbahnen 2 und ermöglicht so eine Verbindung unter eine untere kreisringförmige Kontaktronde am Sandwich 13 hindurch. Außer der Steuerelektrode 15 ist in Fig. 3 auch eine in gleicher Ebene angeordnete Hauptelektrode 17, z.B. eine Kathode, dargestellt. Das keramische Verbindungselement 14 weist eine Metallisierung 18 auf, die von einer Kontaktzone 19 gegenüber der Steuerelektrode 15 durch eine Bohrung 20 im Verbindungselement 14 und weiter an der Unterseite geführt ist bis zum anderen Ende des Verbindungselements 14, wo eine Lötverbindung mit einer Leiterbahn 2 erfolgt. Die Kontaktzone 19 wird mit der Steuerelektrode 15 verlötet. Das Verbindungselement 14 wird mit Hilfe der Figuren 4 bis 6 genauer beschrieben.

Fig. 4 zeigt nochmals das in Fig. 3 bereits dargestellte Verbindungselement 14 als Schnittbild. Das löffelförmige Verbindungselement 14 setzt sich zusammen aus einem Stiel 21 mit rechteckigem Querschnitt und einer runden Erweiterung 22, die an den Innendurchmesser der in Fig. 3 dargestellten unteren Kontaktronde 16 angepaßt ist. Die Dicke des Verbindungselementes 14 entspricht im Bereich des Stiels 21 der Dicke der Leiterbahnen 2 (z.B. 0,5mm) und im Bereich der runden Erweiterung etwa der Dicke der unteren Kontaktronde 16 zuzüglich der Dicke der Leiterbahn 2. Die Kontaktzone 19 kann z.B. wie dargestellt trichterförmig ausgebildet werden zur Aufnahme einer Kugel aus Lot 7. Der Stiel 21 kann z.B. 1mm breit sein und muß mindestens so lang sein, daß er etwa 1 bis 2mm über den äußeren Rand des Leistungshalbleiterbauelements 5 hinausragt. Als Keramikmaterial ist ein in der Dickschichttechnik übliches Material geeignet, z.B. bestehend aus 96% $Al_2O_3$. Für die Metallisierung 18 kann ebenfalls ein in der Dickschichttechnik übliches Metall bzw. eine Kombination von Metallen verwendet werden, z.B. Mo/Mn- oder W-Paste, die in die Keramik an den gewünschten Stellen eingebrannt wird und anschließend, durch stromloses Abscheiden von Nickel oder Gold verstärkt, lötfähig gemacht wird. Möglich ist z.B. auch Einbrennen von PdAg-Pasten allein, ohne weitere Metallauflagen. Die Metallisierung 18 verändert die Abmessungen des Verbindungselements 14 praktisch nicht, da entsprechend den zu führenden kleinen Strömen keine dicke Metallauflage benötigt wird. Die Metallisierung 18 reicht von der Kontaktzone 19 im Bereich einer Steuerelektrode 15 (siehe Fig. 3) über eine Durchkontaktierung durch die Bohrung 20 in der Erweiterung 22 über die Unterseite des Verbindungselements 14 bis zum Ende seines Stiels 21, wobei am Ende über eine Länge von etwa 1mm rund herum eine Metallisierung 18 vorgesehen ist.

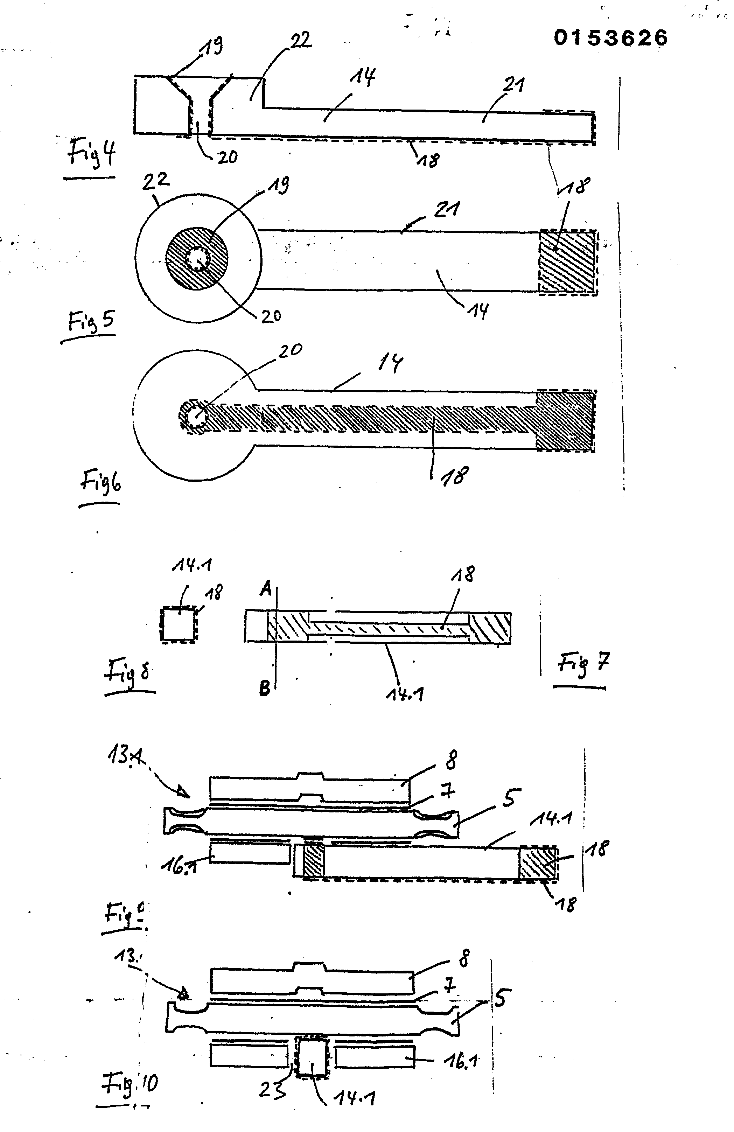

Fig. 5 zeigt eine Ansicht von oben auf das Verbindungselement 14 und Fig. 6 eine Ansicht von unten. Fig. 6 ist zu entnehmen, daß die Metallisierung 18 nicht die ganze Fläche der Unterseite bedeckt, sondern nur eine etwa 0,5mm breite metallisierte Bahn in der Mitte vorgesehen ist.

Die Kontaktzone 19 an dem in den Figuren 3 bis 6 dargestellten Verbindungselement 14 kann auch ohne trichterförmige Erweiterung der Bohrung 20 ausgeführt werden. In diesem Fall wird die Kontaktzone 19 zweckmäßig vorbelotet.

Die Herstellung des Sandwich 13 und die spätere Lötung auf dem Substrat 1 können bei der in den Figuren 2 und 3 dargestellten Anordnung mit dem gleichen Weichlot und bei der gleichen Löttemperatur erfolgen. Bei der zweiten Lötung wird die untere Kontaktronde 16 durch die runde Erweiterung 22 des Verbindungselements 14 fixiert und das Leistungshalbleiterbauelement 5 sowie die obere Kontaktronde 8 durch Kapillarkräfte.

Wendet man für die zweite Lötung ein niedrig schmelzendes Lot und eine tiefere Löttemperatur als bei der Sandwichlötung an, so kann das Verbindungelement 14 etwas einfacher gestaltet werden wie in Fig. 7 dargestellt. Fig. 7 zeigt die Unterseite eines stabförmigen Verbindungselementes 14.1, das keine runde Erweiterung 22 aufweist. An beiden Enden des Verbindungselements 14.1 ist über eine Länge von etwa 1mm eine Metallisierung 18 über den gesamten Umfang vorgesehen, die über ein etwa 0,5mm breites Metallisierungsband auf der Unterseite des Verbindungselements 14.1 miteinander verbunden ist. Das
äußerste Ende des Verbindungelements 14.1 auf der mit
der Steuerelektrode 15 zu kontaktierenden Seite bleibt
jedoch auf einer Länge von etwa 0,5mm frei von einer
Metallisierung 18. Die Metallisierung 18 an den Enden
des Verbindungselements 14.1 wird vorbelotet. Fig. 8
zeigt einen Schnitt durch die in Fig. 7 eingetragene
Ebene A-B.

Fig. 9 (Schnittbild) und Fig. 10 zeigen in zwei verschiedenen Ansichten wie das Verbindungselement 14.1 in
ein Sandwich 13.1 eingesetzt wird, dessen untere kreisringförmige Kontaktronde 16.1 einen Schlitz 23 aufweist,
durch den das Verbindungselement 14.1 geführt wird.

In vorteilhafter Ausgestaltung der Erfindung kann in die
Verbindung zwischen den metallisierten Enden des Verbindungselements 14, 14.1 ein Widerstand durch Einbrennen
integriert werden. Der Widerstand kann z.B. als Beschaltungswiderstand in einer Gate-Zuleitung oder als
Gate-Kathoden-Widerstand verwendet werden.

<u>A n s p r ü c h e</u>

1. Anordnung eines Leistungshalbleiterbauelementes auf einem isolierenden und mit Leiterbahnen versehenen Substrat, wobei das Leistungshalbleiterbauelement mindestens eine allseitig umschlossene Steuerelektrode aufweist, <u>dadurch gekennzeichnet,</u> daß die mit mindestens einer Steuerelektrode (15) und einer Hauptelektrode (17) versehene Seite des Leistungshalbleiterbauelementes (5) dem Substrat (1) zugewandt ist und ein Verbindungselement (14,14.1) aus metallisierter Keramik vorgesehen ist zur Herstellung einer elektrischen Verbindung zwischen der Steuerelektrode (15) und einer Leiterbahn (2) außerhalb des vom Leistungshalbleiterbauelement (5) abgedeckten Bereichs auf dem Substrat (1).

2. Anordnung nach Anspruch 1, dadurch gekennzeichnet, daß das Leistungshalbleiterbauelement (5) als Sandwich (13) ausgeführt ist, mit einer oberen Kontaktronde (8) und einer unteren Kontaktronde (16).

3. Anordnung nach Anspruch 1 oder 2, dadurch gekennzeichnet, daß das Verbindungselement (14) in Ausschnitte (3) in Leiterbahnen (2) eingelegt ist.

4. Anordnung nach Anspruch 2 und 3, dadurch gekennzeichnet, daß das Verbindungselement (14) eine löffelartige Form hat und
-   einen keramischen Stiel (21) mit rechteckigem Querschnitt aufweist, wobei die Dicke des Stiels (21) der Dicke der Leiterbahnen (2) auf dem Substrat (1) entspricht und

an dem mit der Steuerlektrode (15) zu verbindenden Ende eine runde Erweiterung (22) vorgesehen ist, mit einem Durchmesser entsprechend des Innendurchmessers der kreisringförmigen Kontaktronde (16) und einer Dicke entsprechend der Dicke der Kontaktronde (16) zuzüglich der Dicke der Leiterbahnen (2) und

die Erweiterung (22) eine Bohrung (20) aufweist, und

eine metallische Verbindung zwischen einer Kontaktzone (19) auf der Oberseite der Erweiterung (22) und dem anderen Ende des Verbindungselements (14) vorgesehen ist durch eine Metallisierung (18), die durch die Bohrung (20) und auf der Unterseite des Stiels (21) geführt ist.

5. Anordnung nach Anspruch 4, dadurch gekennzeichnet, daß die Bohrung (20) im Verbindungselement (14) auf der oberen Seite trichterförmig erweitert ist.

6. Anordnung nach Anspruch 2 und 3, dadurch gekennzeichnet, daß ein stabförmiges keramisches Verbindungselement (14.1) vorgesehen ist, das durch einen Schlitz (23) in der unteren Kontaktronde (16.1) geführt ist.

7. Anordnung nach Anspruch 6, dadurch gekennzeichnet, daß das stabförmige Verbindungselement (14.1) eine Metallisierung (18) aufweist, die an dem mit der Steuerelektrode (15) zu kontaktierenden Ende mit einem Abstand von ca. 0,5mm vom Rand beginnt, auf einer Länge von etwa 1mm den Umfang des Verbindungselements (14.1) bedeckt und auf der Unterseite des Verbindungselements (14.1) als etwa 0,5mm breites Band geführt ist bis zum anderen Ende, wo sie den ganzen Umfang über die Länge von etwa 1mm bedeckt und an der Stirnfläche endet, wobei die Stirnfläche ebenfalls metallisiert ist.

521/84                              10                      0153626

8. Anordnung nach Anspruch 4 oder 7, dadurch gekennzeichnet, daß die Metallisierung (18) des Verbindungselements (14,14.1) durch Einbrennen einer metallischen Paste in die Keramik hergestellt ist.

9. Anordnung nach Anspruch 4 oder 7, dadurch gekennzeichnet, daß die Metallisierung (18) durch stromlos abgeschiedenes Nickel oder Gold verstärkt wird.

10. Anordnung nach mindestens einem der Ansprüche 1 bis 9, dadurch gekennzeichnet, daß in das Verbindungselement (14,14.1) ein Widerstand integriert ist.

11. Anordnung nach Anspruch 10, dadurch gekennzeichnet, daß der Widerstand durch Einbrennen von Widerstandsmaterial in die Keramik des Verbindungselements (14,14.1) hergestellt ist.

**0153626**

1/2

Fig.1

Fig.2

Fig.3

0153626

Fig 4

Fig 5

Fig 6

Fig 8

Fig 7

Fig 9

Fig 10